# EUROPEAN PATENT APPLICATION

(11) **EP 4 369 399 A1**
(43) Date of publication of application: **15.05.2024**
(21) Application number: 23187675.6
(22) Date of filing: 25.07.2023
(51) Int. Cl.: H01L 25/16, H01L 27/15, H01L 33/00, H01L 33/02, H01L 33/06, H01L 33/14, H01L 33/20, H01L 33/32

(54) **DISPLAY DEVICE AND METHOD OF MANUFACTURING THE SAME**

(30) Priority: 08.11.2022 KR 20220148130
(71) Applicant: Samsung Display Co., Ltd., Yongin-si, Gyeonggi-do 17113 (KR)
(72) Inventor: KIM, Su Jeong, 17113 Yongin-si (KR); MIN, Dae Hong, 17113 Yongin-si (KR)
(74) Representative: Marks & Clerk LLP

(57) **Abstract**

The present application relates to a display device and a method for manufacturing the same. The display device includes: a base layer; and light emitting elements disposed on the base layer, the light emitting elements including an N-type semiconductor layer, a P-type semiconductor layer, and an active layer disposed between the N-type and P-type semiconductor layers. The light emitting elements include a first light emitting element emitting light of a first color and a second light emitting element emitting light of a second color. The N-type semiconductor layer includes a first N-type semiconductor layer of the first light emitting element and a second N-type semiconductor layer of the second light emitting element. The active layer includes a first active layer of the first light emitting element and a second active layer of the second light emitting element. The first and second N-type semiconductor layers are integral with each other, and form a plane surface in an area where the active layer is disposed.

## Description

### BACKGROUND

### 1. Technical Field

Embodiments relate to a display device and a manufacturing method for the display device.

### 2. Description of the Related Art

With the development of information technologies, the importance of a display device for providing a user with information has been increased. The display device includes a light emitting element capable of emitting light. The light emitting element may be a diode including a P-type semiconductor, an N-type semiconductor, and a quantum well structure disposed between the P-type semiconductor and the N-type semiconductor.

In order to manufacture a high-performance display device having a high resolution, it is necessary to miniaturize the size of the light emitting element, and it is necessary to further improve the light emission efficiency of the light emitting element.

Further, it is necessary to resolve a process risk that occurs in a process of manufacturing the light emitting element, and it is necessary to implement a light emitting element structure having higher light emission efficiency.

### SUMMARY

Embodiments provide a display device and a manufacturing method for the display device such that a process risk in a process for manufacturing a light emitting element may be reduced, process efficiency may be improved, and light emission efficiency of the light emitting element may be improved.

However, embodiments of the disclosure are not limited to those set forth herein. The above and other embodiments will become more apparent to one of ordinary skill in the art to which the disclosure pertains by referencing the detailed description of the disclosure given below.

In an embodiment, a display device includes: a base layer; and light emitting elements disposed on the base layer, the light emitting elements including an N-type semiconductor layer, a P-type semiconductor layer, and an active layer disposed between the N-type semiconductor layer and the P-type semiconductor layer, wherein the light emitting elements include a first light emitting element emitting light (e.g. capable of emitting light) of a first color and a second light emitting element emitting light (*e*.*g*. capable of emitting light) of a second color, the N-type semiconductor layer includes a first N-type semiconductor layer of the first light emitting element and a second N-type semiconductor layer of the second light emitting element, the active layer includes a first active layer of the first light emitting element and a second active layer of the second light emitting element, and the first N-type semiconductor layer and the second N-type semiconductor layer are integral with each other, and form a plane surface in an area where the active layer is disposed.

The first light emitting element and the second light emitting element may be commonly connected to a same N-type semiconductor layer.

The display device may further include a cover layer disposed between the light emitting elements adjacent to each other. The N-type semiconductor layer may include a first area and a second area. The first area may overlap the cover layer in a plan view, and the second area may not overlap the cover layer in a plan view. The active layer and the P-type semiconductor layer may be disposed in the second area.

A portion of the N-type semiconductor layer disposed in the second area may not overlap the cover layer in a plan view.

The active layer may include a barrier layer and a well layer. The first active layer and the second active layer may be formed on the plane surface formed by the first N-type semiconductor layer and the second N-type semiconductor layer. The N-type semiconductor layer may be in contact with the active layer to be adjacent to the barrier layer.

The N-type semiconductor layer, the active layer, and the P-type semiconductor layer may be sequentially disposed in a stacked direction. The N-type semiconductor layer may include a silicon dopant. The silicon dopant may have a concentration range within a predetermined range not to form a peak concentration along the stacked direction in the N-type semiconductor layer.

The N-type semiconductor layer may include GaN doped with a first conductivity type dopant. The active layer may include a well layer including InGaN and a barrier layer including GaN. The P-type semiconductor layer may include GaN doped with a second conductivity type dopant.

The light emitting elements may further include a superlattice layer disposed between the active layer and the N-type semiconductor layer and an electron blocking layer disposed between the active layer and the P-type semiconductor layer.

In an embodiment, a method for manufacturing a display device includes: manufacturing light emitting elements; and transferring the light emitting elements on a base layer, wherein the manufacturing of the light emitting elements includes: forming an N-type semiconductor layer on a growth substrate; forming a mask on the N-type semiconductor layer; forming an active layer on the N-type semiconductor layer; and forming a P-type semiconductor layer on the active layer, and the active layer is formed on the N-type semiconductor layer disposed on a lower surface of the mask.

The forming of the mask may include forming a hole exposing the N-type semiconductor layer.

The method may further include performing a thermal cleaning process on the N-type semiconductor layer exposed by the hole.

The performing of the thermal cleaning process may include increasing an initial process temperature to a target temperature range including a target temperature. The target temperature range may be in a range of about 600 °C to about 800 °C.

The target temperature may be about 700 °C. A process temperature in the forming of the active layer may be in a range of a temperature smaller by about 100 °C than the target temperature to a temperature greater by about 100 °C than the target temperature.

The thermal cleaning process may be performed in an environment in which H₂ and NH₃ are simultaneously supplied.

The manufacturing of the light emitting elements may further include forming a superlattice layer before the active layer is formed and forming an electron blocking layer after the active layer is formed.

In an embodiment, a method for manufacturing a display device includes: manufacturing light emitting elements; and transferring the light emitting elements on a base layer, wherein the manufacturing of the light emitting elements includes: forming an N-type semiconductor layer on a growth substrate; forming a mask on the N-type semiconductor layer; performing a thermal cleaning process on the N-type semiconductor layer; forming an active layer on the N-type semiconductor layer; and forming a P-type semiconductor layer on the active layer, the performing of the thermal cleaning process includes: increasing a process temperature at which the thermal cleaning process is performed to a target temperature range; and cleaning the N-type semiconductor layer exposed by the mask within the target temperature range, and the target temperature range overlaps a process temperature range in which the forming of the active layer is performed.

In an embodiment, a method for manufacturing a display device includes: manufacturing light emitting elements; and transferring the light emitting elements on a base layer, the manufacturing of the light emitting elements includes: forming a first light emitting stack member on a growth substrate; forming a second light emitting stack member on the growth substrate; and forming a third light emitting stack member on the growth substrate, the forming of the first light emitting stack member includes: forming an N-type semiconductor layer forming a base; forming, on the N-type semiconductor layer, a first mask including a first hole exposing the N-type semiconductor layer; performing a first thermal cleaning process on the N-type semiconductor layer exposed by the first hole; and forming a first active layer and a first P-type semiconductor layer in the first hole, the forming of the second light emitting stack member includes: forming, on the N-type semiconductor layer, a second mask including a second hole exposing the N-type semiconductor layer; performing a second thermal cleaning process on the N-type semiconductor layer exposed by the second hole; and forming a second active layer and a second P-type semiconductor layer in the second hole, and the forming of the third light emitting stack member includes: forming, on the N-type semiconductor layer, a third mask including a third hole exposing the N-type semiconductor layer; performing a third thermal cleaning process on the N-type semiconductor layer exposed by the third hole; and forming a third active layer and a third P-type semiconductor layer in the third hole.

The first active layer may be formed at a first process temperature. The second active layer may be formed at a second process temperature lower than the first process temperature. The third active layer may be formed at a third process temperature lower than the second process temperature.

The first process temperature may be selected in a temperature range of about 720 °C to about 780 °C, the second process temperature may be selected in a temperature range of about 690 °C to about 730 °C not to overlap the first process temperature, and the third process temperature may be selected in a temperature range of about 600 °C to about 700 °C not to overlap the second process temperature.

The first light emitting stack member may be a stack member forming a blue light emitting element, the second light emitting stack member may be a stack member forming a green light emitting element, and the third light emitting stack member may be a stack member forming a red light emitting element.

At least some of the above and other features of the invention are set out in the claims.

### BRIEF DESCRIPTION OF THE DRAWINGS

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey the scope of the example embodiments to those skilled in the art.

In the drawing figures, dimensions may be exaggerated for clarity of illustration. It will be understood that in the case that an element is referred to as being "between" two elements, it can be the only element between the two elements, or one or more intervening elements may also be present. Like reference numerals refer to like elements throughout.
FIG. 1 is a schematic plan view illustrating a display device according to one or more embodiments.
FIG. 2 is a figure illustrating an example of a pixel shown in FIG. 1.
FIGS. 3 and 4 are schematic views illustrating a light emitting element according to one or more embodiments.
FIG. 5 is a schematic sectional view illustrating a display device according to one or more embodiments.
FIGS. 6 and 7 are flowcharts illustrating a manufacturing method for a display device in accordance with a first embodiment.
FIG. 8 is a graph illustrating a process temperature for each time section in a step of manufacturing a light emitting element.
FIGS. 9 to 14 are schematic process sectional views illustrating the manufacturing method in accordance with the first embodiment.
FIGS. 15 to 17 are schematic sectional views illustrating a manufacturing method for a display device in accordance with a second embodiment.
FIGS. 18 to 32 are schematic views illustrating a specific embodiment of the first embodiment, and are schematic views illustrating a manufacturing method for a display device, which includes a step of manufacturing two or more light emitting elements.
FIGS. 33 to 36 are schematic views illustrating application examples of the display device in accordance with embodiments.

### DETAILED DESCRIPTION OF THE EMBODIMENTS

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the invention.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3 -axis are not limited to three axes of a rectangular coordinate system, such as the X, Y, and Z - axes, and may be interpreted in a broader sense. For example, the DR1-axis, the DR2-axis, and the DR3-axis may be perpendicular to one another, or may represent different directions that are not perpendicular to one another. Further, the X-axis, the Y-axis, and the Z-axis are not limited to three axes of a rectangular coordinate system, such as the x, y, and z axes, and may be interpreted in a broader sense. For example, the X-axis, the Y-axis, and the Z-axis may be perpendicular to one another, or may represent different directions that are not perpendicular to one another. For the purposes of this disclosure, "at least one of A and B" may be construed as understood to mean A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the invention. Further, the blocks, units, and/or modules of some embodiments may be physically combined into more complex blocks, units, and/or modules without departing from the scope of the invention.

The disclosure generally relates to a display device. Hereinafter, a display device and a manufacturing method for a display device according to one or more embodiments will be described with reference to the accompanying drawings.

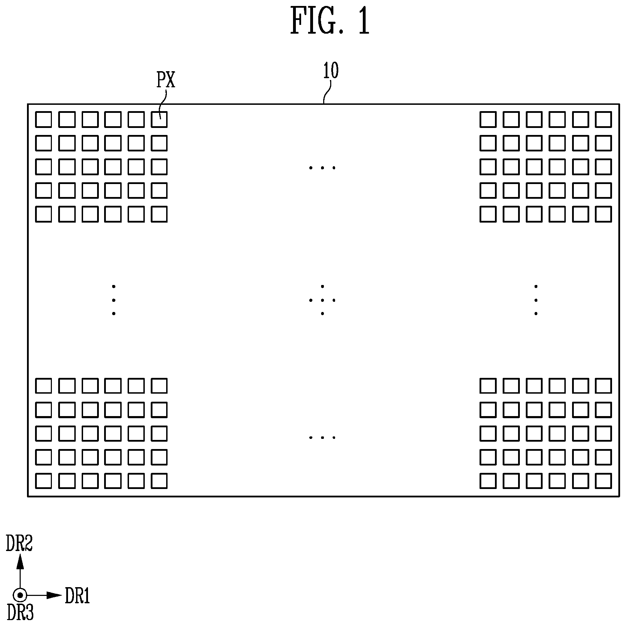

First, a light emitting element LE and a display device 10 according to one or more embodiments will be described with reference to FIGS. 1 to 5.

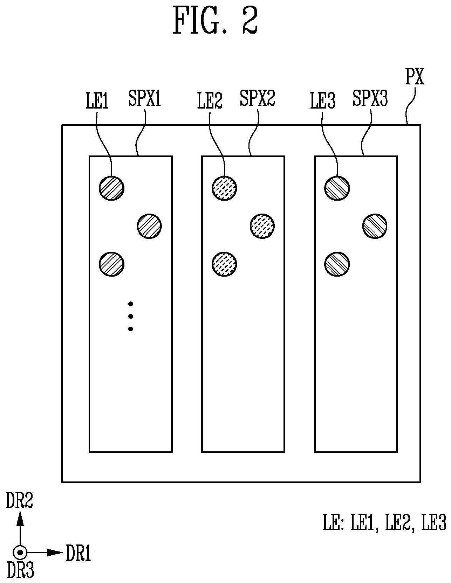

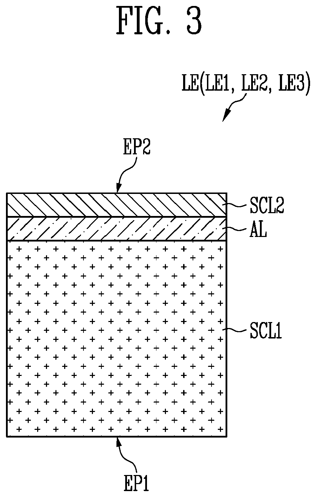

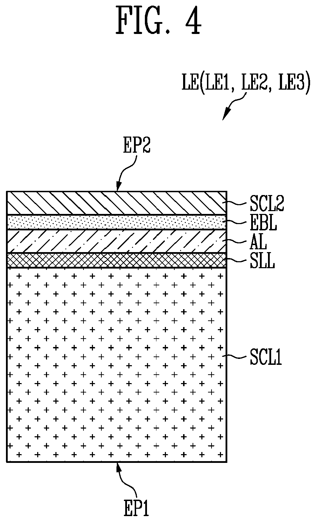

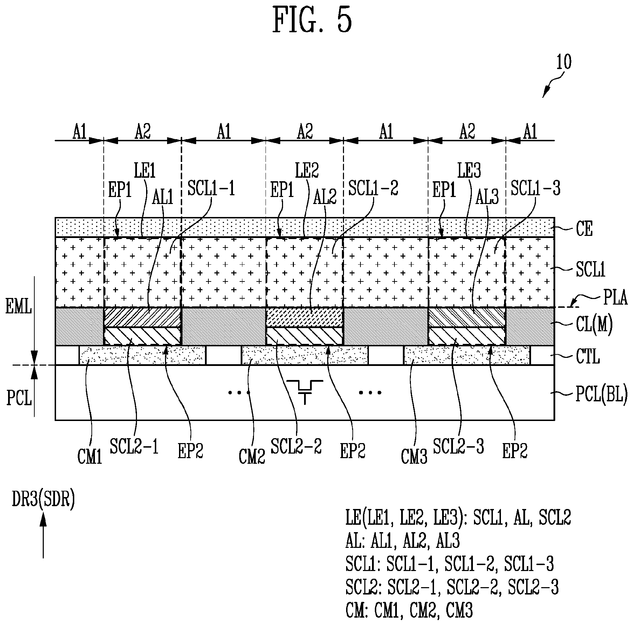

FIG. 1 is a schematic plan view illustrating a display device according to one or more embodiments. FIG. 2 is a figure illustrating an example of a pixel shown in FIG. 1. FIGS. 3 and 4 are schematic views illustrating a light emitting element according to one or more embodiments. FIG. 5 is a schematic sectional view illustrating a display device according to one or more embodiments.

The display device 10 may output optical information. For example, the display device 10 may be a device for displaying a moving image or a still image, and may be applied to various devices. The display device 10 may be formed in a rectangular shape having long sides extending in a first direction DR1 and short sides extending in a second direction DR2 intersecting the first direction DR1. A corner at which the long side extending in the first direction DR1 and the short side extending in the second direction DR2 meet each other may be formed in a round shape having a predetermined curvature or may be formed to have a right angle. The planar shape of the display device 10 is not limited to a quadrangular shape, and the display device 10 may be formed in another polygonal shape, a circular shape, or an elliptical shape. The display device 10 may be formed flat, but embodiments are not limited thereto. For example, the display device 10 may include a curved part which is formed at a left/right end portion and has a constant curvature or a variable curvature. For example, the display device 10 may be formed flexible such that the display device 10 may be warpable, curvable, bendable, foldable or rollable.

The display device 10 may further include pixels PX for displaying an image, scan lines extending in the first direction DR1, and data lines extending in the second direction DR2. The pixels PX may be arranged in a matrix form in the first direction DR1 and the second direction DR2.

Each of the pixels PX may include sub-pixels SPX1, SPX2, and SPX3 as shown in FIG. 2. In FIG. 2, each of the pixels PX may include three sub-pixels SPX1, SPX2, and SPX3, i.e., a first sub-pixel SPX1, a second sub-pixel SPX2, and a third sub-pixel SPX3. However, embodiments are not limited thereto.

The first sub-pixel SPX1, the second sub-pixel SPX2, and the third sub-pixel SPX3 may be connected to any one data line among the data lines and at least one scan line among the scan lines.

Each of the first sub-pixel SPX1, the second sub-pixel SPX2, and the third sub-pixel SPX3 may have a rectangular, square or rhombic planar shape. For example, each of the first sub-pixel SPX1, the second sub-pixel SPX2, and the third sub-pixel SPX3 may have a rectangular planar shape having short sides extending in the first direction DR1 and long sides extending in the second direction DR2 as shown in FIG. 2. In some embodiments, each of the first sub-pixel SPX1, the second sub-pixel SPX2, and the third sub-pixel SPX3 may have a square or rhombic planar shape including sides having a same length in the first direction DR1 and the second direction DR2.

As shown in FIG. 2, the first sub-pixel SPX1, the second sub-pixel SPX2, and the third sub-pixel SPX3 may be arranged in the first direction DR1. In another example, the first sub-pixel SPX1 and any one of the second sub-pixel SPX2 and the third sub-pixel SPX3 may be arranged in the first direction DR1, and the first sub-pixel SPX1 and the other of the second sub-pixel SPX2 and the third sub-pixel SPX3 may be arranged in the second direction DR2.

In another example, the second sub-pixel SPX2 and any one of the first sub-pixel SPX1 and the third sub-pixel SPX3 may be arranged in the first direction DR1, and the second sub-pixel SPX2 and the other of the first sub-pixel SPX1 and the third sub-pixel SPX3 may be arranged in the second direction DR2. In another example, the third sub-pixel SPX3 and any one of the first sub-pixel SPX1 and the second sub-pixel SPX2 may be arranged in the first direction DR1, and the third sub-pixel SPX3 and the other of the first sub-pixel SPX1 and the second sub-pixel SPX2 may be arranged in the second direction DR2. However, the structure in which the first sub-pixel SPX1, the second sub-pixel SPX2, and the third sub-pixel SPX3 are arranged is not limited to an example.

Each of the first sub-pixel SPX1, the second sub-pixel SPX2, and the third sub-pixel SPX3 may include an inorganic light emitting element having an inorganic semiconductor as a light emitting element LE emitting light. The first sub-pixel SPX1 may emit first light, the second sub-pixel SPX2 may emit second light, and the third sub-pixel SPX3 may emit third light.

For example, the light emitting element LE may include a first light emitting element LE1, a second light emitting element LE2, and a third light emitting element LE3. The first sub-pixel SPX1 may include the first light emitting element LE1 that emits the first light. The second sub-pixel SPX2 may include the second light emitting element LE2 that emits the second light. The third sub-pixel SPX3 may include the third light emitting element LE3 that emits the third light.

According to one or more embodiments, the first light may be light of a blue wavelength band, the second light may be light of a green wavelength band, and the third light may be light of a red wavelength band. The red wavelength band may be a wavelength band of about 600 nm to about 750 nm, the green wavelength band may be a wavelength band of about 480 nm to about 560 nm, and the blue wavelength band may be a wavelength band of about 370 nm to about 460 nm. However, embodiments are not limited thereto.

As shown in FIG. 2, an area (or size) of the first sub-pixel SPX1, an area (or size) of the second sub-pixel SPX2, and an area (or size) of the third sub-pixel SPX3 may be the substantially same as each other, but embodiments are not limited thereto. At least one of the area of the first sub-pixel SPX1, the area of the second sub-pixel SPX2, and the area of the third sub-pixel SPX3 may be different from another of the area of the first sub-pixel SPX1, the area of the second sub-pixel SPX2, and the area of the third sub-pixel SPX3. In another example, any two of the area of the first sub-pixel SPX1, the area of the second sub-pixel SPX2, and the area of the third sub-pixel SPX3 may be the substantially same as each other, and the other of the first sub-pixel SPX1, the area of the second sub-pixel SPX2, and the area of the third sub-pixel SPX3 may be different from the two of the area of the first sub-pixel SPX1, the area of the second sub-pixel SPX2, and the area of the third sub-pixel SPX3. In another example, the area of the first sub-pixel SPX1, the area of the second sub-pixel SPX2, and the area of the third sub-pixel SPX3 may be different from one another.

Referring to FIGS. 3 and 4, the light emitting element LE may emit light. The light emitting element LE includes an N-type semiconductor layer SCL1, a P-type semiconductor layer SCL2, and an active layer AL between the N-type semiconductor layer SCL1 and the P-type semiconductor layer SCL2.

The light emitting element LE may have various sizes (or areas). For example, the light emitting element LE may be a size of micro scale to nano scale. The size of the light emitting element LE is not limited to a specific numerical value range.

The light emitting element LE may have a first end portion EP1 and a second end portion EP2. In some embodiments, the N-type semiconductor layer SCL1 may be adjacent to the first end portion EP1 of the light emitting element LE, and the P-type semiconductor layer SCL2 may be adjacent to the second end portion EP2 of the light emitting element LE.

The N-type semiconductor layer SCL1 may be disposed on the active layer AL, and may include a semiconductor layer having a type different from a type of the P-type semiconductor layer SCL2. For example, the N-type semiconductor layer SCL1 may include an N-type semiconductor material. For example, the N-type semiconductor layer SCL1 may include at least one semiconductor material selected from the group consisting of InAlGaN, GaN, AlGaN, InGaN, AlN, and InN, and include an N-type semiconductor material doped with a first conductivity type dopant such as Si, Ge or Sn. However, embodiments are not limited to the above-described example. The N-type semiconductor layer SCL1 may include various materials. For example, the N-type semiconductor layer may include GaN doped with a first conductivity type dopant.

The active layer AL is disposed between the N-type semiconductor layer SCL1 and the P-type semiconductor layer SCL2. The active layer AL may include a single-quantum well structure or a multi-quantum well structure. The position of the active layer AL is not limited to a specific example, and may be variously changed according to the kind of the light emitting element LE.

The active layer AL may include a well layer and a barrier layer, which are used to form a quantum well structure. In some embodiments, the active layer AL may include InGaN as the well layer, and include GaN as the barrier layer. However, embodiments are not limited thereto.

The P-type semiconductor layer SCL2 may be disposed on the active layer AL, and include a semiconductor layer having a type different from the type of the N-type semiconductor layer SCL1. For example, the P-type semiconductor layer SCL2 may include a P-type semiconductor material. For example, the P-type semiconductor layer SCL2 may include at least one semiconductor material selected from the group consisting of InAlGaN, GaN, AlGaN, InGaN, AlN, and InN, and include a P-type semiconductor material doped with a second conductivity type dopant such as Ga, B or Mg. However, embodiments are not limited to the above-described example. The P-type semiconductor layer SCL2 may include various materials. For example, P-type semiconductor layer may include GaN doped with a second conductivity type dopant.

In some embodiments, the light emitting element LE may further include an electron blocking layer EBL and a superlattice layer SLL (see FIG. 4).

The electron blocking layer EBL may be disposed between the active layer AL and the P-type semiconductor layer SCL2. The electron blocking layer EBL may block at least some of electrons between the active layer AL and the P-type semiconductor layer SCL2, thereby improving the recombination efficiency of electron-hole pairs for light emission. In some embodiments, the electron blocking layer EBL may include a material having an energy band gap greater than an energy band gap of the P-type semiconductor layer SCL2 so as to prevent overflow of electrons. For example, the electron blocking layer EBL may include AlGaN doped with Mg.

The superlattice layer SLL may be disposed between the active layer AL and the N-type semiconductor layer SCL1. The superlattice layer SLL may have a structure in which at least two layers having different compositions are alternately stacked. For example, the superlattice layer SLL may have a structure in which a GaN layer and an InGaN layer are alternately disposed. In some embodiments, the superlattice layer SLL may reduce stress between the N-type semiconductor layer SCL1 and the active layer AL.

However, the structure of the light emitting element LE is not limited to the above-described example. For example, an electrode layer (e.g., an ohmic electrode) may be further adjacent to the second end portion EP2 of the light emitting element LE.

In the case that a voltage which is a threshold voltage or higher is applied to the first end portion EP1 and the second end portion EP2 of the light emitting element LE, electron-hole pairs may be recombined in the active layer AL, and the light emitting element LE may emit light. The light emission of the light emitting element LE may be controlled by using such a principle, so that the light emitting element LE may be used as a light source for various devices.

Referring to FIG. 5, the display device 10 may include a pixel circuit layer PCL and a light-emitting-element layer EML.

The pixel circuit layer PCL may be a layer including pixel circuits for driving light emitting elements LE. The pixel circuit layer PCL may include a base layer BL, metal layers for forming the pixel circuits, and insulating layers disposed between the metal layers. In some embodiments, the base layer BL may be a base substrate or a base member, which is used to support other components of the display device 10. The base layer BL may be a rigid substrate made of a glass material. For example, the base layer BL may be a silicon substrate or a sapphire substrate (e.g., a substrate including Al₂O₃). In another example, the base layer BL may be a flexible substrate which is bendable, foldable, rollable, and the like. The base layer BL may include an insulating material including polymer resin such as polyimide. In some embodiments, the pixel circuits may include a thin film transistor. The pixel circuits may further include a storage capacitor. The pixel circuits may be electrically connected to the light emitting elements LE, to provide an electrical signal for emitting light by the light emitting elements LE.

The light-emitting-element layer EML may be disposed on the pixel circuit layer PCL. The light-emitting-element layer EML may include a first electrode CM, light emitting elements LE, and a second electrode CE. In some embodiments, the light-emitting-element layer EML may further include a cover layer CL and an intermediate layer CTL.

The first electrode CM may be disposed on the pixel circuit layer PCL. The first electrode CM may be disposed on the bottom surface (or lower surface) of the light emitting element LE to be electrically connected to the light emitting element LE. For example, the first electrode CM may be electrically connected to the light emitting element LE through a second end portion EP2 adjacent to a P-type semiconductor layer SCL2 of the light emitting element LE.

The first electrode CM may be electrically connected to the pixel circuit (e.g., a driving transistor and the like) formed in the pixel circuit layer PCL. Accordingly, the first electrode CM may transmit an electrical signal (e.g., a driving signal as an anode signal) for driving the light emitting elements LE. The second electrode CE may be electrically connected to a power line, to supply a voltage of the power line to the light emitting element LE. The second electrode CE may be a cathode electrode, and may receive a cathode signal.

The first electrode CM may include a (1-1)th electrode CM1 electrically connected to a first light emitting element LE1, a (1-2)th electrode CM2 electrically connected to a second light emitting element LE2, and a (1-3)th electrode CM3 electrically connected to a third light emitting elementLE3. The (1-1)th electrode CM1, the (1-2)th electrode CM2, and the (1-3)th electrode CM3 may be separated (or spaced apart) from each other. Accordingly, the light emitting elements LE of different sub-pixels SPX1, SPX2, and SPX3 may be individually or independently driven.

The second electrode CE may be disposed on the top surface (or upper surface) of the light emitting element LE to be electrically connected to the light emitting element LE. For example, the second electrode CE may be electrically connected to the light emitting element LE through a first end portion EP1 adjacent to an N-type semiconductor layer SCL1 of the light emitting element LE.

In some embodiments, the first electrode CM may be a pixel electrode for the light emitting element LE, and the second electrode CE may be a common electrode for the light emitting elements LE. The first electrode CM and the second electrode CE may face each other. The light emitting elements LE may be disposed between the first electrode CM and the second electrode CE.

The first electrode CM and the second electrode CE may include a conductive material. For example, the first electrode CM may include at least one selected from the group consisting of silver (Al), magnesium (Mg), aluminium (Al), platinum (Pt), palladium (Pd), gold (Au), nickel (Ni), neodymium (Nd), iridium (Ir), chromium (Cr), and titanium (Ti). The second electrode CE may include at least one selected from the group consisting of indium tin oxide (ITO), indium zinc oxide (IZO), zinc oxide (ZnO), indium gallium zinc oxide (IGZO), or indium tin zinc oxide (ITZO), and a conductive polymer such as poly(3,4-ethylenedioxythiophene) (PEDOT). However, embodiments are not limited to the above-described example.

The intermediate layer CTL may be disposed on the pixel circuit layer PCL, and be disposed between first electrodes CM (e.g., in a plan view or a horizontal direction). In an example, the intermediate layer CTL may be a transparent adhesive layer (or gluing layer). However, embodiments are not limited thereto, and the intermediate layer CTL may include an organic material.

The cover layer CL may be disposed between the pixel circuit layer PCL and the N-type semiconductor layer SCL1. The cover layer CL may be disposed between light emitting elements LE adjacent to each other. The cover layer CL may be in contact with the N-type semiconductor layer SCL1. The cover layer CL may be adjacent (e.g., directly adjacent) to an active layer AL and the P-type semiconductor layer SCL2.

For example, the cover layer CL may be disposed between active layers AL of the light emitting elements LE (e.g., in a plan view or a horizontal direction). The cover layer CL may be disposed between P-type semiconductor layers SCL2 of the light emitting elements LE (e.g., in a plan view or a horizontal direction).

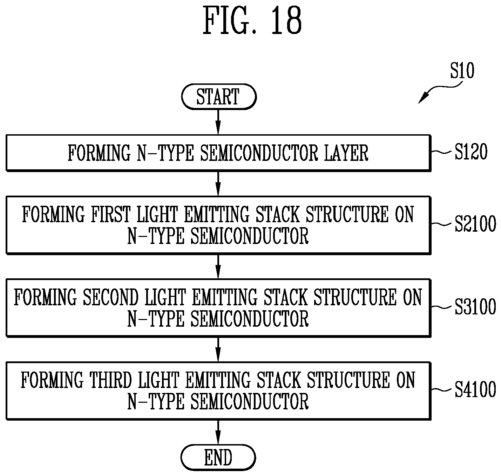

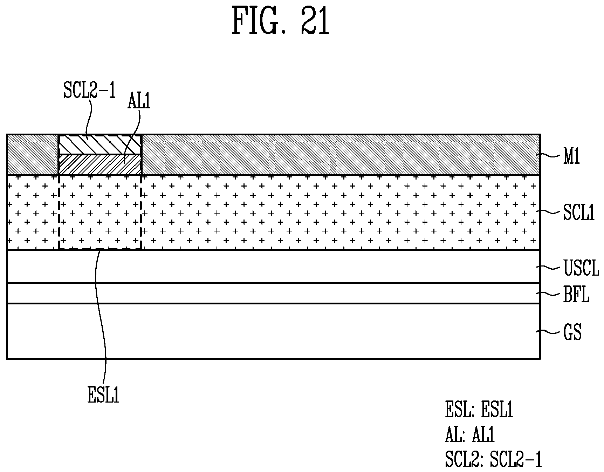

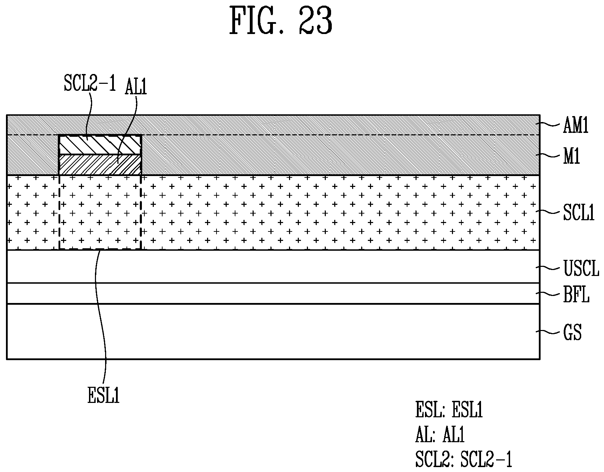

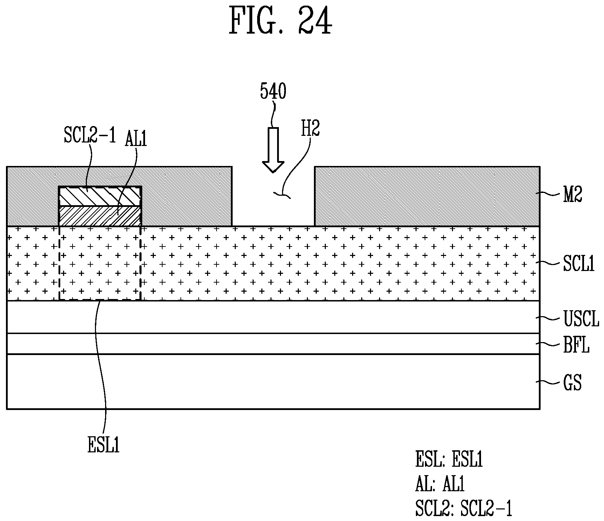

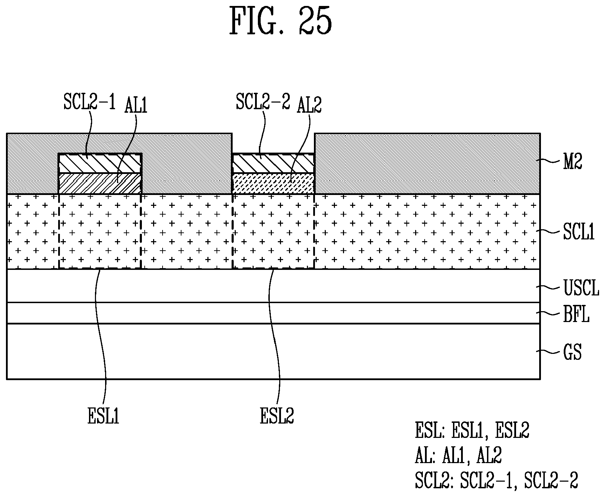

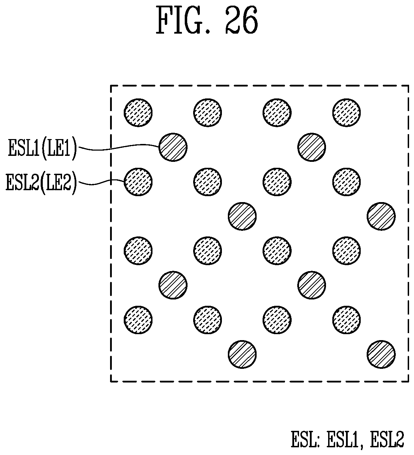

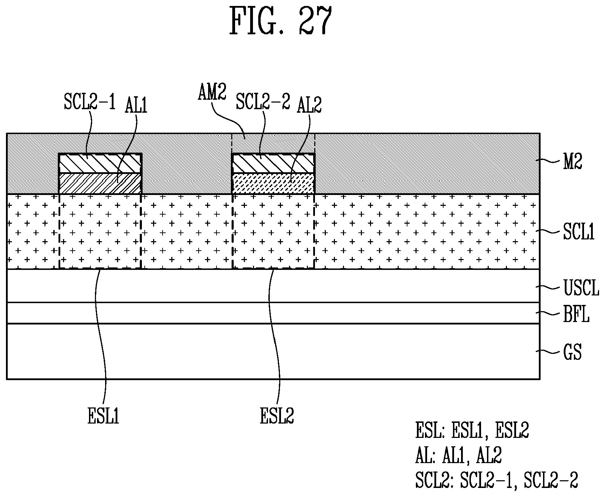

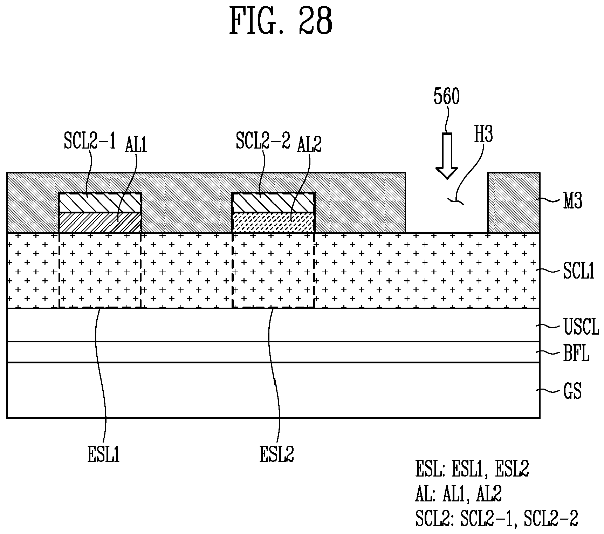

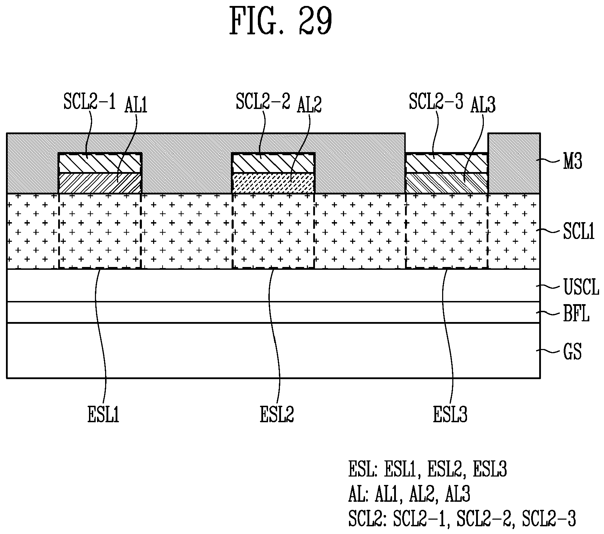

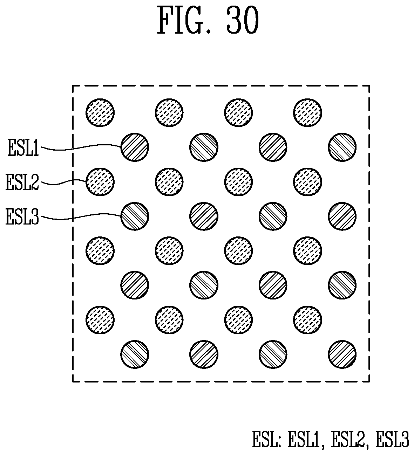

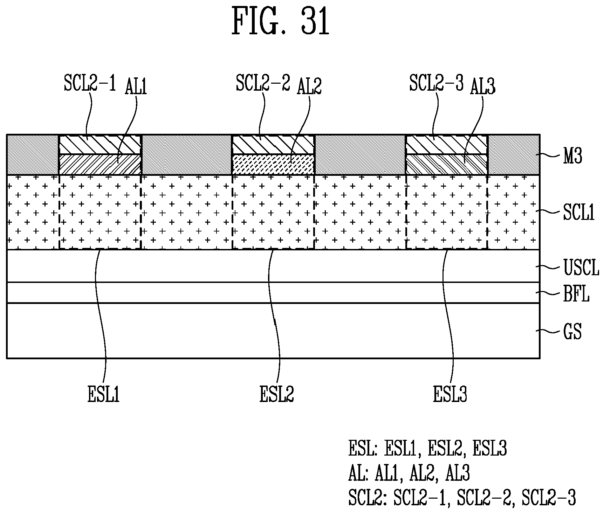

In some embodiments, the cover layer CL may be a mask M for patterning the active layers AL of the respective light emitting elements LE. The mask M may be a first mask M1, a second mask M2, or a third mask M3, which will be described below with reference to, for example FIGS. 18 to 32. In some embodiments, the cover layer CL may expose at least a portion of the N-type semiconductor layer SCL1, and the active layer AL and the P-type semiconductor layer SCL2 may be patterned on the N-type semiconductor layer SCL1 exposed by the cover layer CL, so that a diode structure of the light emitting element LE may be formed.

The cover layer CL may include various insulating materials. For example, the cover layer CL may include silicon oxide (SiOₓ). However, embodiments are not limited thereto. In some embodiments, the cover layer CL may include silicon nitride (SiNₓ).

The light emitting elements LE may be disposed on the first electrode CM, to be electrically connected to the first electrode CM. The light emitting elements LE may be disposed on the bottom surface (or lower surface) of the second electrode CE, to be electrically connected to the second electrode CE. The light emitting elements LE may be provided in the respective sub-pixels SPX1, SPX2, and SPX3.

The active layer AL may include a first active layer AL1 for the first light emitting element LE1, a second active layer AL2 for the second light emitting element LE2, and a third active layer AL3 for the third light emitting element LE3.

The P-type semiconductor layer SCL2 may include a first P-type semiconductor layer SCL2-1 for the first light emitting element LE1, a second P-type semiconductor layer SCL2-2 for the second light emitting element LE2, and a third P-type semiconductor layer SCL2-3 for the third light emitting element LE3.

According to one or more embodiments, the N-type semiconductor layer SCL1 may form a N-type semiconductor structure of each of the first light emitting element LE1, the second light emitting element LE2, and the third light emitting element LE3.

For example, N-type semiconductor layers SCL1 of the first light emitting element LE1, the second light emitting element LE2, and the third light emitting element LE3 may be integral with each other. The first light emitting element LE1, the second light emitting element LE2, and the third light emitting element LE3 may share the N-type semiconductor layer SCL1 or may include the same N-type semiconductor layer SCL1. In some embodiments, the active layer AL and the P-type semiconductor layer SCL2 of each of the first light emitting element LE1, the second light emitting element LE2, and the third light emitting element LE3 may be formed by being sequentially patterned on a same N-type semiconductor layer SCL1.

According to one or more embodiments, the N-type semiconductor layer SCL1 may not include any structure protruding along a stacked direction SDR of the N-type semiconductor layer SCL1, the active layer AL, and a P-type semiconductor layer SCL2 (e.g., a third direction DR3 as a thickness direction of the pixel circuit layer PCL).

For example, the N-type semiconductor layer SCL1 may include a first area A1 overlapping the cover layer CL and a second area A2 not overlapping the cover layer CL, in a plan view. The N-type semiconductor layer SCL1 may form a same plane PLA in the first area A1 and the second area A2. For example, the N-type semiconductor layer SCL1 may include a first N-type semiconductor layer SCL1-1 of the first light emitting element LE1, a second N-type semiconductor layer SCL1-2 of the second light emitting element LE2, and a third N-type semiconductor layer SCL1-3 of the third light emitting element LE3. The first N-type semiconductor layer SCL1-1, the second N-type semiconductor layer SCL1-2, and the third N-type semiconductor layer SCL1-3 may form a plane surface (or a flat surface) without protruding in areas where the fist active layer AL1, the second active layer AL2, and the third active layer AL3 are disposed. In some embodiments, the active layer AL and the P-type semiconductor layer SCL2 may be disposed in the second area A2.

For example, a portion of the N-type semiconductor layer SCL1 disposed in the second area A2 may not overlap the cover layer CL along a planar direction of the pixel circuit layer PCL (e.g., a planar direction of the base layer BL). The planar direction of the pixel circuit layer PCL may be a direction perpendicular to the third direction DR3 (or a horizontal direction), and may mean a direction of a plane formed by the first direction DR1 and the second direction DR2.

According to one or more embodiments, the active layers AL may be formed (e.g., directly formed) on the N-type semiconductor layer SCL1 forming a base of the light emitting elements LE. Accordingly, an additional N-type semiconductor structure may not be formed on the N-type semiconductor layer SCL1 forming the base, and the active layer AL may be patterned. For example, at least one of barrier layers of the active layer AL may be adjacent (e.g., directly adjacent) to the N-type semiconductor layer SCL1 forming the base. The active layer AL may be patterned in a state in which the additional N-type semiconductor structure is not formed on the N-type semiconductor layer SCL1 forming the base.

According to one or more embodiments, as the additional N-type semiconductor structure is not formed on the N-type semiconductor layer SCL1 forming the base, a charge movement path may be decreased, and accordingly, the effect that a driving voltage of the light emitting element LE is decreased may be improved.

For example, as the additional N-type semiconductor structure is not formed on the N-type semiconductor layer SCL1 forming the base, a surface area extending in a lateral direction (e.g., a length direction of the light emitting elements LE) may be minimized, and thus a leakage current may be decreased or minimized.

For example, in the case that the additional N-type semiconductor structure is to be formed on the N-type semiconductor layer SCL1 forming the base, the thickness of a mask M for forming the additional N-type semiconductor structure may be required to become larger. However, in some embodiments, the additional N-type semiconductor structure may not be essentially required, and hence the thickness of the mask M may be decreased. Accordingly, process cost may be reduced.

In some embodiments, the N-type semiconductor layer SCL1 may include a dopant. For example, the N-type semiconductor layer SCL1 may include a silicon dopant so as to improve crystallinity and to improve light emission characteristics. According to one or more embodiments, the silicon dopant may be formed with a concentration gradient in the N-type semiconductor layer SCL1. For example, the silicon dopant may be provided in (or may have) a concentration range within a predetermined range along the stacked direction SDR in the N-type semiconductor layer SCL1. For example, the silicon dopant may be provided in (or may have) a concentration range of 10¹⁸/cm³ to 10²⁰/cm³.

The silicon dopant may not have a peak concentration excessively exceeding the concentration range within the predetermined range in the N-type semiconductor layer SCL1. This means that the active layer AL may be formed (e.g., directly formed) on the N-type semiconductor layer SCL1 without re-forming the additional N-type semiconductor structure on the N-type semiconductor layer SCL1 forming the base. The peak concentration means a peak concentration exceeding the upper limit of a predetermined concentration range within a local analysis section.

For example, when a separate N-type semiconductor structure is re-formed on the N-type semiconductor layer SCL1 forming a base, some of the silicon dopants included in the re-formed separate N-type semiconductor structure may permeate into the N-type semiconductor layer SCL1 forming the base. As a result, the silicon dopants may form a peak concentration in the N-type semiconductor layer SCL1. In other words, in some embodiments, silicon dopants may not form a peak concentration which excessively exceeds a predetermined concentration range in the N-type semiconductor layer SCL1, which may mean that a separate N-type semiconductor structure is not formed on the N-type semiconductor layer SCL1.

The first electrode CM may be a bonding electrode. The light emitting elements LE may be bonded (or coupled) to the first electrode CM. For example, the light emitting elements LE may be transferred on the first electrode CM by using various transfer methods. The light emitting elements LE may be bonded (or coupled) to the first electrode CM by using a bonding method, and be electrically connected to the first electrode CM. The bonding method may include an anisotropic conductive film (ACF) bonding method, a laser assist bonding (LAB) method using laser, an ultrasonic bonding method, a ball grid array (BGA) method, a thermocompression (TC) bonding method, and the like. The TC bonding method may mean a method in which, after the light emitting element LE and the first electrode CM are in contact with each other, the light emitting element LE and the first electrode CM are electrically and physically connected to each other by heating the light emitting element LE and the first electrode CM at a temperature higher than melting points of the light emitting element LE and the first electrode CM and by applying a pressure to the light emitting element LE and the first electrode CM.

The stacked structure of the display device 10 is not limited to the above-described example. In some embodiments, the display device 10 may further include additional layers (e.g., a color filter, an outer film, and the like).

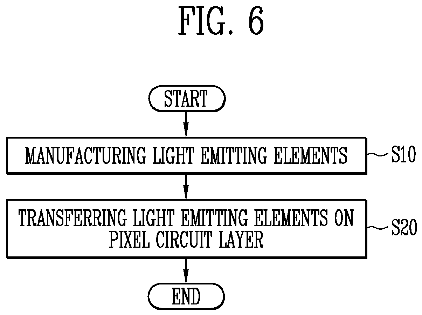

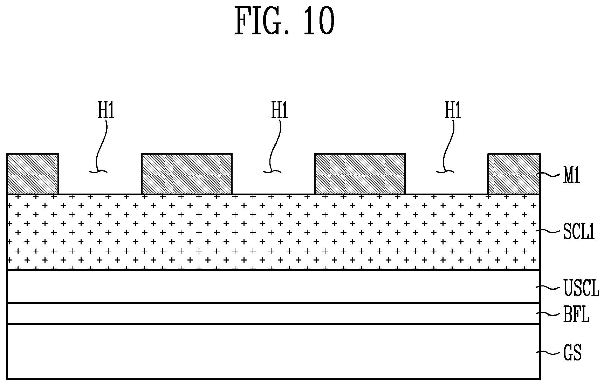

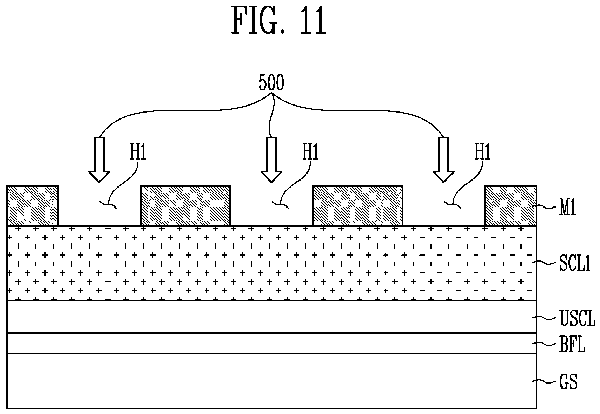

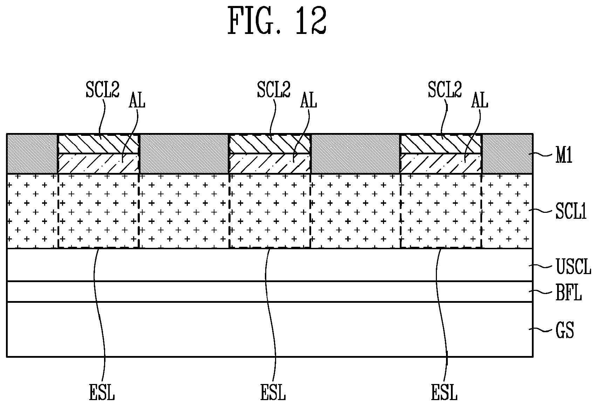

Hereinafter, a manufacturing method for the display device 10 according to one or more embodiments will be described with reference to FIGS. 6 to 32. In FIGS. 6 to 32, redundant descriptions of portions, which are same as (or similar to) those of the above-described embodiment, will be simplified or will not be repeated for descriptive convenience.

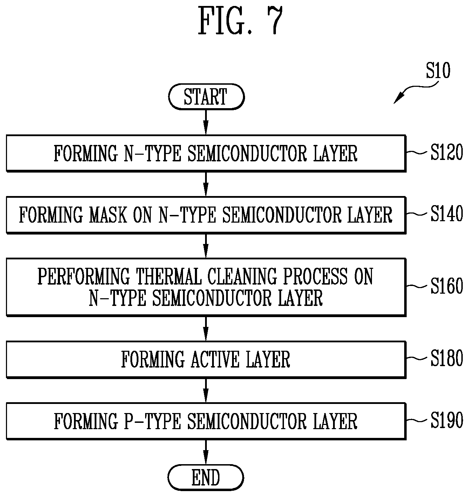

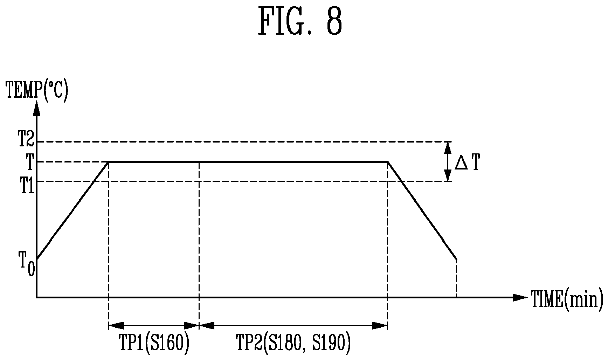

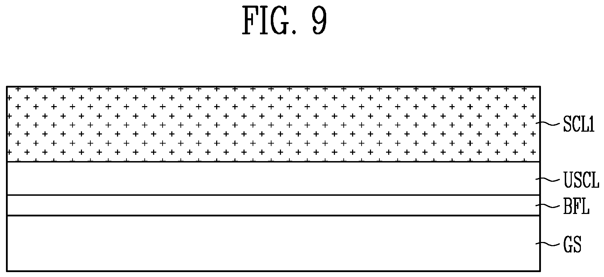

First, FIGS. 6 to 14 illustrate a manufacturing method for the display device 10 in accordance with a first embodiment. FIGS. 6 to 14 are schematic views illustrating the manufacturing method in accordance with the first embodiment. FIGS. 6 and 7 are flowcharts illustrating the manufacturing method in accordance with the first embodiment. FIG. 7 illustrates some steps of the manufacturing method in accordance with the first embodiment, and may be a flowchart illustrating a step of manufacturing of a light emitting element LE. FIG. 8 is a graph illustrating a process temperature for each time section in the step of manufacturing the light emitting element. FIGS. 9 to 14 are schematic process sectional views illustrating the manufacturing method in accordance with the first embodiment.

Referring to FIGS. 6 and 7, the manufacturing method for the display device 10 may include a step S10 of manufacturing light emitting elements and a step S20 of transferring the light emitting elements on a pixel circuit layer. In some embodiments, the step S10 of manufacturing the light emitting elements may include a step S120 of forming an N-type semiconductor layer SCL1, a step S140 of forming a mask M on the N-type semiconductor layer SCL1, step S160 of performing a thermal cleaning process on the N-type semiconductor layer SCL1, a step S180 of forming an active layer AL, and a step S190 of forming a P-type semiconductor layer SCL2.

Referring to FIGS. 6, 7, and 9, in the step S 120 of forming the N-type semiconductor layer SCL1, a buffer layer BFL, an undoped semiconductor layer USCL, and an N-type semiconductor layer SCL1 may be formed on a growth substrate GS.

The growth substrate GS may be a base plate for growing a target material. For example, the growth substrate GS may be a wafer for epitaxial growth on a material. The growth substrate GS may be a GaAs, GaP or InP substrate, but the material for forming the growth substrate GS is not limited to a specific example.

The buffer layer BFL may be formed on the growth substrate GS, to improve the crystallinity of semiconductor layers formed on the growth substrate GS. In some embodiments, the buffer layer BFL may include GaN or A1N, but the material for forming the buffer layer BFL is not limited to a specific example.

The undoped semiconductor layer USCL may be disposed on the buffer layer BFL, to reduce a defect of the semiconductor layers formed on the growth substrate GS. In some embodiments, the undoped semiconductor layer USCL may include GaN which is not doped with any separate dopant, but the material for forming the undoped semiconductor layer USCL is not limited to a specific example.

The N-type semiconductor layer SCL1 may be epitaxially grown on the undoped semiconductor layer USCL. The N-type semiconductor layer SCL1 may include at least one of the above-described N-type semiconductor materials. In some embodiments, N-type semiconductor layer SCL1 may include GaN doped with silicon.

Referring to FIGS. 6, 7, and 10, in the step 140 of forming the mask M on the N-type semiconductor layer SCL1, a first mask M1 may be formed on the N-type semiconductor layer SCL1.

The first mask M1 may include an insulating layer, and be patterned to cover some areas of the N-type semiconductor layer SCL1. In some embodiments, the first mask M1 may include silicon oxide (SiOₓ). In some embodiments, the first mask M1 may include silicon nitride (SiNₓ). The first mask M1 may expose a portion of the N-type semiconductor layer SCL1, thereby forming a first hole H1. A position of the first hole H1 may correspond to a position for forming an active layer AL.

Referring to FIGS. 6, 7, 8, and 11, in the step S160 of performing the thermal cleaning process on the N-type semiconductor layer SCL1, a thermal cleaning process 500 may be applied to at least a portion of the N-type semiconductor layer SCL1 exposed by the first mask M1.

In the step S160, a surface of the N-type semiconductor layer SCL1 exposed by the first mask M1 may be cleaned. For example, as the thermal cleaning process 500 is performed, the surface of the exposed N-type semiconductor layer SCL1 may be planarized, and an impurity on the surface of the exposed N-type semiconductor layer SCL1 may be removed. For example, the step S160 may be performed during a first period TP1 (see FIG. 8).

According to one or more embodiments, an initial temperature T₀ may be increased to a target temperature range ΔT so as to apply the thermal cleaning process 500. The target temperature range ΔT may at least include a target temperature T. The target temperature range ΔT may be a range between a first temperature T1 and a second temperature T2. In the case that the step S160 of performing the thermal cleaning process on the N-type semiconductor layer SCL1 is performed, a process temperature may be maintained within the target temperature range ΔT. In some embodiments, the target temperature range ΔT may be in a range of about 600 °C to about 800 °C. For example, the target temperature range ΔT may be about 700 °C or about 750 °C. In some embodiments, in the case that the target temperature range ΔT exceeds about 800 °C, excessive process cost may be spent to develop a process environment for subsequently forming the active layer AL, and the active layer AL may be damaged. In the case that the target temperature range ΔT is less than about 600 °C, it may be difficult to appropriately perform the cleaning process on the N-type semiconductor layer SCL1.

According to one or more embodiments, the thermal cleaning process 500 may be performed in an environment in which H₂ and NH₃ are simultaneously supplied. The thermal cleaning process 500 may be appropriately performed under the target temperature range ΔT as a relatively low temperature. According to one or more embodiments, it is not essentially required to excessively increase the process temperature, and thus the process cost may be reduced.

For example, the target temperature range ΔT for performing the thermal cleaning process 500 may be within a predetermined difference (e.g., about 100 °C) from the process temperature in the case that the active layer AL is formed. For example, the target temperature range ΔT for performing the thermal cleaning process 500 may be in a range of a first temperature smaller by about 100 °C than the target temperature T to a second temperature greater by about 100 °C than the target temperature T in the case that the active layer AL is formed. In some embodiments, the target temperature range ΔT for performing the thermal cleaning process 500 may overlap the process temperature in the case that the active layer AL is formed. It may be appropriate to develop the process environment for forming the active layer AL after the thermal cleaning process 500 is performed.

Referring to FIGS. 6, 7, 8, and 12, in the step S180 of forming the active layer AL and the step S190 of forming the P-type semiconductor layer SCL2, the active layer AL and a P-type semiconductor layer SCL2 may be formed on some areas of the N-type semiconductor layer SCL1 exposed by the first mask M1.

In the steps S180 and S190, a portion of the N-type semiconductor layer SCL1, the active layer AL, and the P-type semiconductor layer SCL2 may form a light emitting stack structure (or light emitting stack member) ESL having a diode structure. For example, the steps S180 and S190 may be performed during a second period TP2 (see FIG. 8).

The active layer AL may be epitaxially grown and patterned on the N-type semiconductor layer SCL1 in an area in which the first mask M1 is not disposed. In some embodiments, the active layer AL may include InGaN as a well layer, and include GaN as a barrier layer.

The P-type semiconductor layer SCL2 may be epitaxially grown and patterned on the active layer AL in the area in which the first mask M1 is not disposed. The P-type semiconductor layer SCL2 may include at least one of the above-described P-type semiconductor materials. In some embodiments, the P-type semiconductor layer SCL2 may include GaN doped with Mg.

According to one or more embodiments, a process temperature at which the step S 180 of forming the active layer AL and the step S190 of forming the P-type semiconductor layer SCL2 are performed may be included in the target temperature range ΔT at which the above-described thermal cleaning process 500 may be performed.

For example, the target temperature range ΔT may correspond to a process temperature for growing the active layer AL and the P-type semiconductor layer SCL2. For example, after the process temperature for performing the thermal cleaning process 500 is increased, it may not be separately required to perform an additional temperature increase. In some embodiments, the process temperature at which the step S 180 of forming the active layer AL and the step S190 of forming the P-type semiconductor layer SCL2 are performed may be lower than or equal to the target temperature T.

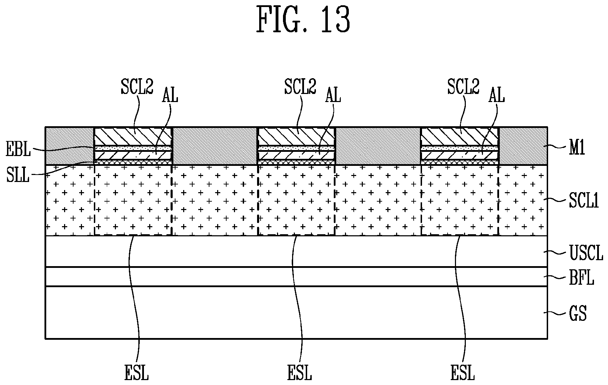

Referring to FIG. 13, a step of forming a superlattice layer SLL on the bottom surface (or lower surface) of the active layer AL and a step of forming an electron blocking layer EBL on the top surface (or upper surface) of the active layer AL may be further performed. For example, the superlattice layer SLL and the electron blocking layer EBL may be selectively patterned on some areas of the N-type semiconductor layer SCL1, in which the first mask M1 is not disposed.

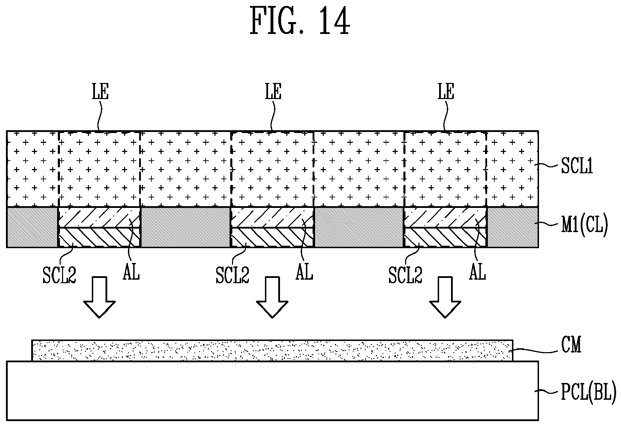

Referring to FIGS. 6 and 14, in the step S20 of transferring the light emitting elements on the pixel circuit layer, light emitting elements LE may be transferred on a pixel circuit layer PCL.

In order to perform the step S20, a portion of the N-type semiconductor layer SCL1 may be cut after the light emitting stack structure ESL is formed, thereby forming the light emitting elements LE separated from the growth substrate GS. For example, the portion of the N-type semiconductor layer SCL1 may be cut by a laser lift-off process, but embodiments are not limited thereto.

In the step S20, the manufactured light emitting elements LE may be transferred such that the P-type semiconductor layer SCL2 may face a first electrode CM on the pixel circuit layer PCL. Accordingly, the light emitting elements LE may be electrically connected to the first electrode CM.

In the step S20, the first mask M1 may not be separately removed. The first mask M1 may be provided as the above-described cover layer CL.

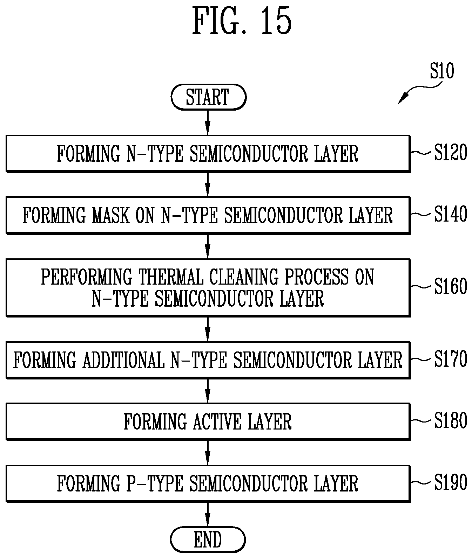

FIGS. 15 to 17 illustrate a manufacturing method for the display device 10 in accordance with a second embodiment. In FIGS. 15 to 17, redundant descriptions of portions, which are same as (or similar to) those of the above-described embodiment will be simplified or will not be repeated for descriptive convenience.

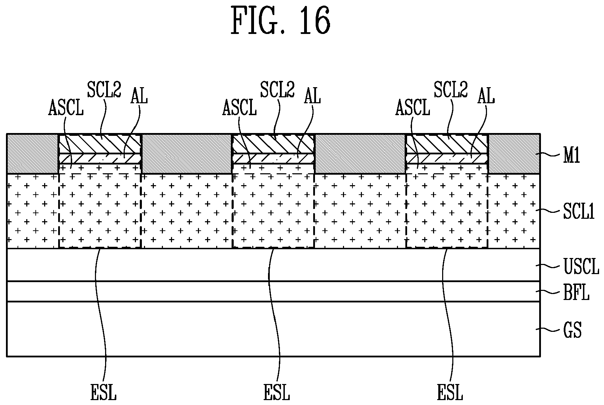

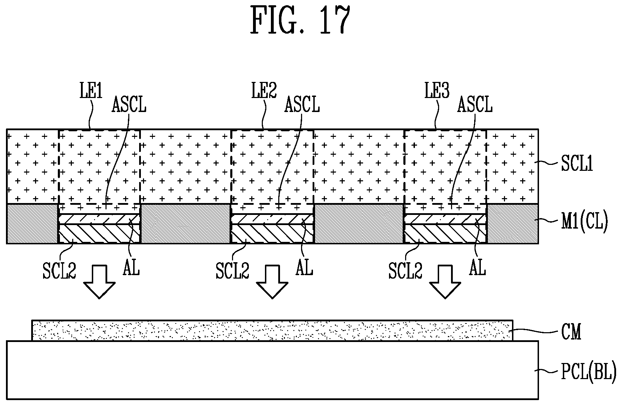

FIGS. 15 to 17 are schematic sectional views illustrating the manufacturing method for the display device in accordance with the second embodiment. FIG. 15 illustrates in detail some steps of the manufacturing method for the display device 10 in accordance with the second embodiment, and may be a flowchart illustrating a step of manufacturing a light emitting element LE. FIGS. 16 and 17 are schematic process sectional views illustrating the manufacturing method in accordance with the second embodiment. In FIGS. 15 to 17, redundant descriptions of portions, which are same as (or similar to) those of the above-described embodiment, will be simplified or will not be repeated for descriptive convenience.

The step of manufacturing the light emitting element LE in accordance with the second embodiment is different from the step of manufacturing the light emitting element LE in accordance with the first embodiment, in that the step of manufacturing the light emitting element LE in accordance with the second embodiment may further include a step S170 of forming an additional N-type semiconductor layer ASCL.

Referring to FIGS. 15 to 17, the step S170 of forming the additional N-type semiconductor layer ASCL may be further performed, so that an additional N-type semiconductor layer ASCL may be further formed on the N-type semiconductor layer SCL1 exposed by the first mask M1.

The additional N-type semiconductor layer ASCL may be selectively patterned in some areas before the active layer AL is formed. According to one or more embodiments, the additional N-type semiconductor layer ASCL, portions of the N-type semiconductor layer SCL1, the active layer AL, and the P-type semiconductor layer SCL2 may form a light emitting stack structure ESL (or light emitting element LE).

Like the first embodiment, in the second embodiment, the thermal cleaning process 500 may be performed within the target temperature range ΔT. Accordingly, process cost may be reduced, and the target temperature range ΔT may correspond to a process temperature for forming the active layer AL and the P-type semiconductor layer SCL2. Thus, process convenience may be enhanced.

A manufacturing method for the display device 10, which includes a step of manufacturing at least two light emitting elements LE, as a specific embodiment of the first embodiment will be described with reference to FIGS. 6and 18 to 32. In FIGS. 18 to 32, redundant descriptions of portions, which are same as (or similar to) those of the above-described embodiment will be simplified or will not be repeated for descriptive convenience.

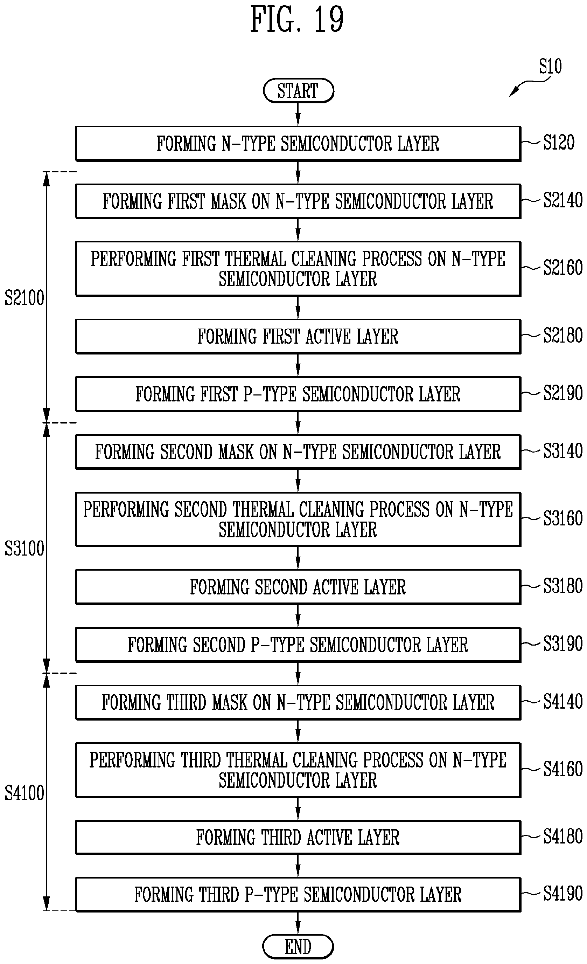

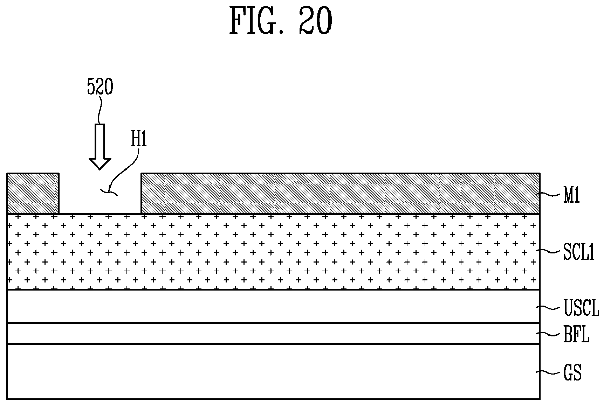

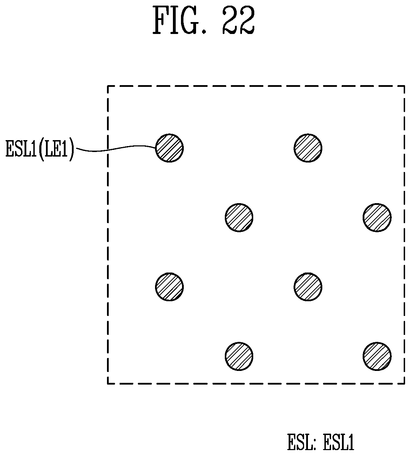

FIGS. 18 to 32 are schematic views illustrating a specific embodiment of the first embodiment, and are schematic views illustrating a manufacturing method for the display device, which includes a step of manufacturing at least two light emitting elements. FIGS. 18 and 19 illustrate in detail some steps of the manufacturing method for the display device 10 in accordance with the first embodiment, and may be flowcharts illustrating a step of manufacturing the light emitting element LE. FIGS. 20, 21, 23 to 25, 27 to 29, 31, and 32 are schematic process sectional views illustrating a manufacturing method of the display device, which corresponds to FIGS. 18 and 19. FIGS. 22, 26, and 30 are schematic process plan views illustrating the manufacturing method of the display device, which corresponds to FIGS. 18 and 19.

Referring to FIGS. 18 and 19, a step S10 of manufacturing light emitting elements in accordance with the embodiment may include a step S120 of forming an N-type semiconductor layer SCL1, a step S2100 of forming a first light emitting stack structure (or first light emitting stack member) on an N-type semiconductor layer SCL1, a step S3100 of forming a second light emitting stack structure (or second light emitting stack member) on the N-type semiconductor layer SCL1, and a step S4100 of forming a third light emitting stack structure (or third light emitting stack member) on the N-type semiconductor layer SCL1. The step S2100 of forming the first light emitting stack structure on the N-type semiconductor layer SCL1 may include a step S2140 of forming a first mask M1 on the N-type semiconductor layer SCL1, a step S2160 of performing a first thermal cleaning process 520 on the N-type semiconductor layer SCL1, a step S2180 of forming a first active layer AL1, and a step S2190 of forming a first P-type semiconductor layer SCL2-1. The step S3100 of forming the second light emitting stack structure on the N-type semiconductor layer SCL1 may include a step S3140 of forming a second mask M2 on the N-type semiconductor layer SCL1, a step S3160 of performing a second thermal cleaning process 540 on the N-type semiconductor layer SCL1, a step S3180 of forming a second active layer AL2, and a step S3190 of forming a second P-type semiconductor layer SCL2-2. The step S4100 of forming the third light emitting stack structure on the N-type semiconductor layer SCL1 may include a step S4140 of forming a third mask M3 on the N-type semiconductor layer SCL1, a step S4160 of performing a third thermal cleaning process 560 on the N-type semiconductor layer SCL1, a step S4180 of forming a third active layer AL3, and a step S4190 of forming a third P-type semiconductor layer SCL2-3.

Referring to FIGS. 18 to 20, in the step S2140 of forming the first mask M1 on the N-type semiconductor layer SCL1 and the step S2160 of performing the first thermal cleaning process 520 on the N-type semiconductor layer SCL1, the first mask M1 may be formed on an N-type semiconductor layer SCL1. For example, a first thermal cleaning process 520 may be performed on a partial area of the N-type semiconductor layer SCL1 exposed by the first mask M1.

In the steps S2140 and S2160, the first mask M1 may form a first hole H1, and the N-type semiconductor layer SCL1 may be exposed in the first hole H1.

In the steps S2140 and S2160, a process temperature may be increased to the target temperature range ΔT such that the first thermal cleaning process 520 may be performed. Accordingly, a top surface (or upper surface) of the N-type semiconductor layer SCL1 exposed in the first hole H1 may be planarized.

Referring to FIGS. 18, 19, 21, and 22, in the step S2180 of forming the first active layer AL1 and the step S2190 of forming the first P-type semiconductor layer SCL2-1, a first active layer AL1 and a first P-type semiconductor layer SCL2-1 may be patterned on the N-type semiconductor layer SCL1 exposed by the first mask M1.

In the steps S2180 and S2190, a portion of the N-type semiconductor layer SCL1, the first active layer AL1, and the first P-type semiconductor layer SCL2-1 may form a first light emitting stack structure ESL1 for forming a first light emitting element LE1.

According to one or more embodiments, a process temperature in the case that the first active layer AL1 is patterned may be lower than or equal to a temperature at which the first thermal cleaning process 520 is performed. For example, the first active layer AL1 may be an active layer AL of the first light emitting element LE1 emitting blue light, and the process temperature in the case that the first active layer AL1 is patterned may be in a range of about 720 °C to about 780 °C.

Referring to FIGS. 18, 19, 23, and 24, in the step S3140 of forming the second mask M2 on the N-type semiconductor layer SCL1 and the step S3160 of performing the second thermal cleaning process 540 on the N-type semiconductor layer SCL1, a second mask M2 may be formed on the N-type semiconductor layer SCL1. For example, a second thermal cleaning process 540 may be performed on a partial area of the N-type semiconductor layer SCL1 exposed by the second mask M2.

In the steps S3140 and S3160, a first additional mask layer AM1 may be formed on the first mask M1, and the first mask M1 and the first additional mask layer AM1 may be patterned, thereby forming the second mask M2. The second mask M2 may form a second hole H2, and the N-type semiconductor layer SCL1 may be exposed in the second hole H2.

In the steps S3140 and S3160, a process temperature may be increased to the target temperature range ΔT such that the second thermal cleaning process 540 may be performed. Accordingly, a top surface (or upper surface) of the N-type semiconductor layer SCL1 exposed in the second hole H2 may be planarized.

Referring to FIGS. 18, 19, 25, and 26, in the step S3180 of forming the second active layer AL2 and the step S3190 of forming the second P-type semiconductor layer SCL2-2, a second active layer AL2 and a second P-type semiconductor layer SCL2-2 may be patterned on the N-type semiconductor layer SCL1 exposed by the second mask M2.

In the steps S3180 and S3190, a portion of the N-type semiconductor layer SCL1, the second active layer AL2, and the second P-type semiconductor layer SCL2-2 may form a second light emitting stack structure ESL2 for forming a second light emitting element LE2.

According to one or more embodiments, a process temperature in the case that the second active layer AL2 is patterned may be lower than or equal to a temperature at which the second thermal cleaning process 540 is performed. For example, the second active layer AL2 may be an active layer AL of the second light emitting element LE2 emitting green light, and the process temperature in the case that the second active layer AL2 is patterned may be in a range of about 690 °C to about 730 °C. The process temperature in the case that the second active layer AL2 is formed may be selected not to overlap the process temperature in the case that the first active layer AL1 is formed.

Referring to FIGS. 18, 19, 27, and 28, in the step S4140 of forming the third mask M3 on the N-type semiconductor layer SCL1 and the step S4160 of performing the third thermal cleaning process 560 on the N-type semiconductor layer SCL1, a third mask M3 may be formed on the N-type semiconductor layer SCL1. For example, a third thermal cleaning process 560 may be performed on a partial area of the N-type semiconductor layer SCL1 exposed by the third mask M3.

In the steps S4140 and S4160, a second additional mask layer AM2 may be formed on the second mask M2, and the second mask M2 and the second additional mask layer AM2 may be patterned, thereby forming the third mask M3. The third mask M3 may form a third hole H3, and the N-type semiconductor layer SCL1 may be exposed in the third hole H3.

In the steps S4140 and S4160, a process temperature may be increased to the target temperature range ΔT such that the third thermal cleaning process 560 may be performed. Accordingly, a top surface (or upper surface) of the N-type semiconductor layer SCL1 exposed in the third hole H3 may be planarized.

Referring to FIGS. 18, 19, 29, and 30, in the step S4180 of forming the third active layer AL3 and the step S4190 of forming the third P-type semiconductor layer SCL2-3, a third active layer AL3 and a third P-type semiconductor layer SCL2-3 may be patterned on the N-type semiconductor layer SCL1 exposed by the third mask M3.

In the steps S4180 and S4190, a portion of the N-type semiconductor layer SCL1, the third active layer AL3, and the third P-type semiconductor layer SCL2-3 may form a third light emitting stack structure ESL3 for forming a third light emitting element LE3.

According to one or more embodiments, a process temperature in the case that the third active layer AL3 is patterned may be lower than or equal to a temperature at which the third thermal cleaning process 560 is performed. For example, the third active layer AL3 may be an active layer AL of the third light emitting element LE3 emitting red light, and the process temperature in the case that the third active layer AL3 is patterned may be in a range of about 600 °C to about 700 °C. The process temperature in the case that the third active layer AL3 is formed may be selected not to overlap the process temperature in the case that the second active layer AL2 is formed.

According to one or more embodiments, an active layer AL relatively strong against temperature among the active layers AL may be previously patterned. For example, a process temperature for forming each of the active layers AL may be high in an order of the first active layer AL1, the second active layer AL2, and the third active layer AL3. The first active layer AL1 may be formed at a first process temperature, the second active layer AL2 may be formed at a second process temperature, and the third active layer AL3 may be formed at a third process temperature. The second process temperature may be lower than the first process temperature, and the third process temperature may be lower than the second process temperature.

For example, the first active layer AL1, the second active layer AL2, and the third active layer AL3 are sequentially formed, and a process temperature for an active layer AL formed subsequently may be lower than the first process temperature. Damage of an active layer AL previously formed to be relatively strong against a high temperature environment due to a process temperature of an active layer AL formed subsequently may be reduced.

For example, the process temperature for each of the active layers AL1, AL2, and AL3 may be set within a predetermined difference from the temperature at which the thermal cleaning process 500 is performed. Thus, damage with respect to the active layers AL1, AL2, and AL3 may be prevented, and unnecessary expense requirement may be prevented.

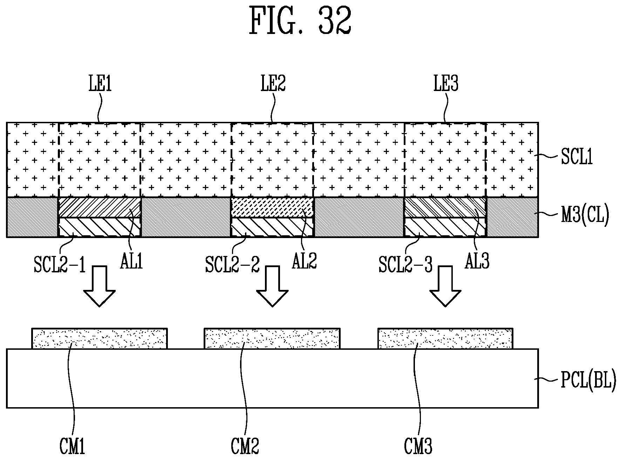

Referring to FIG. 32, the manufactured first light emitting element LE1, the manufactured second light emitting element LE2, and the manufactured third light emitting element LE3 may be respectively transferred on a (1-1)th electrode CM1, a (1-2)th electrode CM2, and a (1-3)th electrode CM3 on the pixel circuit layer PCL.

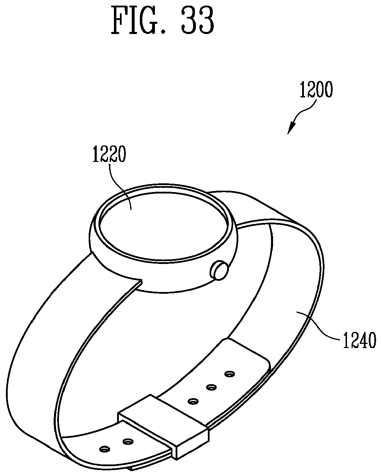

Hereinafter, application fields of the display device 10 in accordance with embodiments will be described with reference to FIGS. 33 to 36. However, the application fields of the display device 10 are not limited to examples which will be described below. FIGS. 33 to 36 are schematic views illustrating application examples of the display device in accordance with embodiments.

First, referring to FIG. 33, the display device 10 may be applied to a smart watch 1200 including a display part 1220 and a strap part 1240.

The smart watch 1200 may be a wearable electronic device, and may have a structure in which the strap part 1240 is mounted on a wrist of a user. The display device 10 may be applied to the display part 1220, so that image data including time information may be provided to the user.

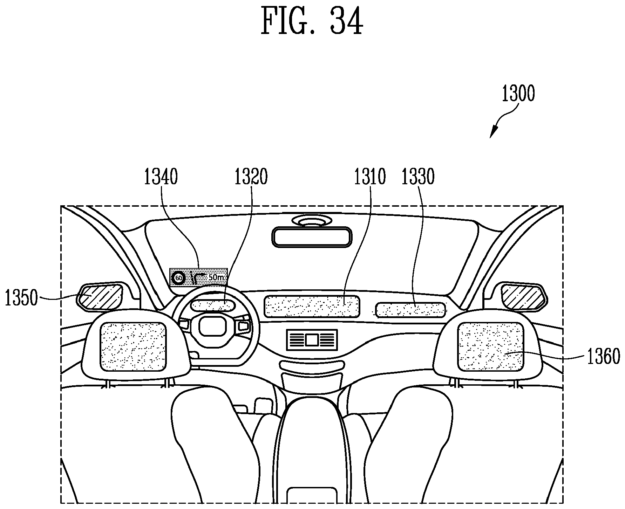

Referring to FIG. 34, the display device 10 may be applied to an automotive display 1300. The automotive display 1300 may be an electronic device installed at the inside/outside of a vehicle to provide image data.

For example, the display device 10 may be applied to at least one of an infotainment panel 1310, a cluster 1320, a co-driver display 1330, a head-up display 1340, a side mirror display 1350, and a rear seat display 1360, which are provided in the vehicle.

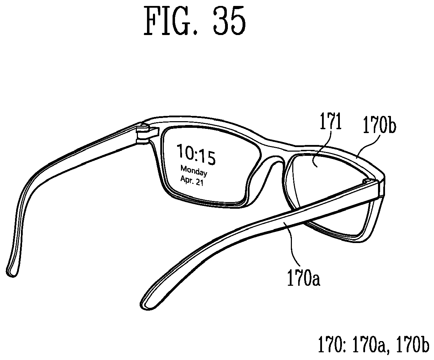

Referring to FIG. 35, the display device 10 may be applied to smart glasses including a frame 170 and a lens part 171. The smart glasses may be a wearable electronic device which may be worn on the face of a user, and may have a structure in which a portion of the frame 170 is folded or unfolded. For example, the smart glasses may be a wearable device for Augmented Reality (AR).

The frame 170 may include a housing 170b supporting the lens part 171 and a leg part 170a for allowing the user to wear the smart glasses. The leg part 170a may be connected to the housing 170b by a hinge to be folded or unfolded.

A battery, a touch pad, a microphone, a camera, and the like may be built in the frame 170. For example, a projector for outputting light, a processor for controlling a light signal, etc., and the like may be embedded in the frame 170.

The lens part 171 may be an optical member which transmits light therethrough or reflects light thereby. The lens part 171 may include glass, transparent synthetic resin, etc.

Also, the lens part 171 may reflect an image caused by a light signal transmitted from the projector of the frame 170 by a rear surface (e.g., a surface in a direction facing eyes of the user) of the lens part 171, thereby enabling the eyes of the user to recognize the image. For example, as shown in the drawing, the user may recognize information including time, data, and the like, which are displayed on the lens part 171. For example, the lens part 171 may be a kind of display device, and the display device 10 may be applied to the lens part 171.

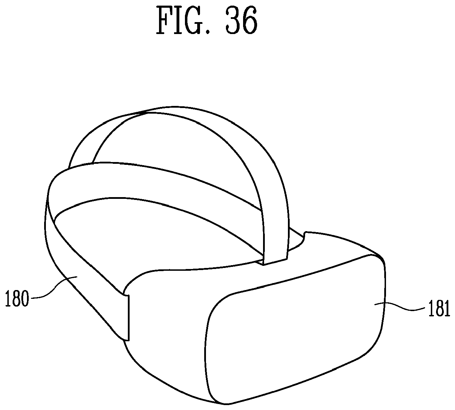

Referring to FIG. 36, the display device 10 may be applied to a Head Mounted Display (HMD) including a head mounted band 180 and a display accommodating case 181. The HMD may be a wearable electronic device which is worn on the head of a user.

The head mounted band 180 may be a part connected to the display accommodating case 181, to fix the display accommodating case 181. In the drawing, it is illustrated that the head mounted band 180 surrounds a top surface (or upper surface) and side surfaces (e.g., opposite side surfaces) of the head of the user. However, embodiments are not limited thereto. The head mounted band 180 may be used to fix the HMD to the head of the user, and may be formed in the shape of a glasses frame or a helmet.

The display accommodating case 181 may accommodate the display device, and may include at least one lens. The at least one lens may be a part which displays an image to the user. For example, the display device 10 may be applied to a left-eye lens and a right-eye lens, which are implemented in the display accommodating case 181.

In accordance with the disclosure, a display device and a manufacturing method for a display device, in which a risk is decreased in a process for manufacturing a light emitting element may be implemented, so that process efficiency may be improved and light emission efficiency may be improved.

In concluding the detailed description, those skilled in the art will appreciate that many variations and modifications may be made to the embodiments without substantially departing from the principles and scope of the disclosure. Therefore, the disclosed embodiments are used in a generic and descriptive sense only and not for purposes of limitation.

## Claims

1. A display device comprising:
a base layer; and
light emitting elements disposed on the base layer, the light emitting elements including an N-type semiconductor layer, a P-type semiconductor layer, and an active layer disposed between the N-type semiconductor layer and the P-type semiconductor layer, wherein
the light emitting elements include a first light emitting element emitting light of a first color and a second light emitting element emitting light of a second color,
the N-type semiconductor layer includes a first N-type semiconductor layer of the first light emitting element and a second N-type semiconductor layer of the second light emitting element,
the active layer includes a first active layer of the first light emitting element and a second active layer of the second light emitting element, and
the first N-type semiconductor layer and the second N-type semiconductor layer are integral with each other, and form a plane surface in an area where the active layer is disposed.

2. The display device of claim 1, wherein the first light emitting element and the second light emitting element include a same N-type semiconductor layer,
the display device further comprises a cover layer disposed between the light emitting elements adjacent to each other,
the N-type semiconductor layer includes a first area and a second area,
the first area overlaps the cover layer in a plan view,
the second area does not overlap the cover layer in a plan view,
the active layer and the P-type semiconductor layer are disposed in the second area, and
a portion of the N-type semiconductor layer disposed in the second area does not overlap the cover layer in a plan view

3. The display device of claim 1 or claim 2, wherein
the active layer includes a barrier layer and a well layer,
the first active layer and the second active layer are formed on the plane surface formed by the first N-type semiconductor layer and the second N-type semiconductor layer, and
the N-type semiconductor layer is in contact with the active layer to be adjacent to the barrier layer.

4. The display device of any one of claims 1 to 3, wherein
the N-type semiconductor layer, the active layer, and the P-type semiconductor layer are sequentially disposed in a stacked direction,
the N-type semiconductor layer includes a silicon dopant, and
the silicon dopant has a concentration range within a predetermined range not to form a peak concentration along the stacked direction in the N-type semiconductor layer.

5. The display device of any one of claims 1 to 4, wherein
the N-type semiconductor layer includes GaN doped with a first conductivity type dopant,
the active layer includes a well layer including InGaN and a barrier layer including GaN, and
the P-type semiconductor layer includes GaN doped with a second conductivity type dopant.

6. The display device of claim 5, wherein
the light emitting elements further include:
a superlattice layer disposed between the active layer and the N-type semiconductor layer, and
an electron blocking layer disposed between the active layer and the P-type semiconductor layer.

7. A method for manufacturing a display device, the method comprising:
manufacturing light emitting elements; and
transferring the light emitting elements on a base layer, wherein
the manufacturing of the light emitting elements includes:
forming an N-type semiconductor layer on a growth substrate;
forming a mask on the N-type semiconductor layer;
forming an active layer on the N-type semiconductor layer; and
forming a P-type semiconductor layer on the active layer, and
the active layer is formed on the N-type semiconductor layer disposed on a lower surface of the mask.

8. The method of claim 7, wherein the forming of the mask includes forming a hole exposing the N-type semiconductor layer, and
the method further comprises: performing a thermal cleaning process on the N-type semiconductor layer exposed by the hole.

9. The method of claim 8, wherein
the performing of the thermal cleaning process includes increasing an initial process temperature to a target temperature range including a target temperature,
the target temperature range is in a range of about 600 °C to about 800 °C,
the target temperature is about 700 °C, and
a process temperature in the forming of the active layer is in a range of a temperature smaller by about 100 °C than the target temperature to a temperature greater by about 100 °C than the target temperature.

10. The method of claim 8 or claim 9, wherein the thermal cleaning process is performed in an environment in which H₂ and NH₃ are simultaneously supplied.

11. The method of any one of claims 7 to 10, wherein
the manufacturing of the light emitting elements further includes:
forming a superlattice layer before the active layer is formed, and
forming an electron blocking layer after the active layer is formed.

12. A method for manufacturing a display device according to claim 7, wherein the method further comprises performing a thermal cleaning process on the N-type semiconductor layer after the forming of the mask on the N-type semiconductor layer and prior to the forming of the active layer on the N-type semiconductor layer; wherein the performing of the thermal cleaning process includes:
increasing a process temperature at which the thermal cleaning process is performed to a target temperature range; and
cleaning the N-type semiconductor layer exposed by the mask within the target temperature range, and
the target temperature range overlaps a process temperature range in which the forming of the active layer is performed.

13. A method for manufacturing a display device, the method comprising:
manufacturing light emitting elements; and
transferring the light emitting elements on a base layer, wherein
the manufacturing of the light emitting elements includes:
forming a first light emitting stack member on a growth substrate;
forming a second light emitting stack member on the growth substrate; and
forming a third light emitting stack member on the growth substrate,
the forming of the first light emitting stack member includes:
forming an N-type semiconductor layer forming a base;
forming, on the N-type semiconductor layer, a first mask including a first hole exposing the N-type semiconductor layer;
performing a first thermal cleaning process on the N-type semiconductor layer exposed by the first hole; and
forming a first active layer and a first P-type semiconductor layer in the first hole,
the forming of the second light emitting stack member includes:
forming, on the N-type semiconductor layer, a second mask including a second hole exposing the N-type semiconductor layer;
performing a second thermal cleaning process on the N-type semiconductor layer exposed by the second hole; and
forming a second active layer and a second P-type semiconductor layer in the second hole, and
the forming of the third light emitting stack member includes:
forming, on the N-type semiconductor layer, a third mask including a third hole exposing the N-type semiconductor layer;
performing a third thermal cleaning process on the N-type semiconductor layer exposed by the third hole; and
forming a third active layer and a third P-type semiconductor layer in the third hole.

14. The method of claim 13, wherein
the first active layer is formed at a first process temperature,
the second active layer is formed at a second process temperature lower than the first process temperature,
the third active layer is formed at a third process temperature lower than the second process temperature,
the first process temperature is selected in a temperature range of about 720 °C to about 780 °C,
the second process temperature is selected in a temperature range of about 690 °C to about 730 °C not to overlap the first process temperature, and
the third process temperature is selected in a temperature range of about 600 °C to about 700 °C not to overlap the second process temperature.

15. The method of claim 14, wherein
the first light emitting stack member is a stack member forming a blue light emitting element,
the second light emitting stack member is a stack member forming a green light emitting element, and
the third light emitting stack member is a stack member forming a red light emitting element.
